# EUROPÄISCHE PATENTSCHRIFT

(11) **EP 1 430 544 B1**
(45) Veröffentlichungstag und Bekanntmachung des Hinweises auf die Patenterteilung: **15.09.2010**
(21) Anmeldenummer: 02781115.7
(22) Anmeldetag: 27.09.2002
(51) Int. Cl.: H01L 33/20, H01L 33/44

(54) **STRAHLUNGSEMITTIERENDER HALBLEITERCHIP, VERFAHREN ZU DESSEN HERSTELLUNG UND STRAHLUNGSEMITTIERENDES BAUELEMENT**
RADIATION-EMITTING SEMICONDUCTOR CHIP, METHOD FOR PRODUCTION THEREOF AND RADIATION-EMITTING COMPONENT
PUCE DE SEMI-CONDUCTEUR EMETTANT UN RAYONNEMENT, SON PROCEDE DE PRODUCTION ET COMPOSANT EMETTANT UN RAYONNEMENT

(30) Priorität: 28.09.2001 DE 10148227
(43) Veröffentlichungstag der Anmeldung: 23.06.2004
(73) Patentinhaber: OSRAM Opto Semiconductors GmbH, 93055 Regensburg (DE)
(72) Erfinder: FEHRER, Michael, 93077 Bad Abbach (DE); HÄRLE, Volker, 93164 Waldetzenberg (DE); KÜHN, Frank, 81739 München (DE); ZEHNDER, Ulrich, 93049 Regensburg (DE)
(74) Vertreter: Epping - Hermann - Fischer
(86) Internationale Anmeldenummer: PCT/DE2002/003668
(87) Internationale Veröffentlichungsnummer: WO 2003/030271

(56) Entgegenhaltungen:
- DE-A- 2 554 029
- DE-A- 4 130 878
- DE-A- 4 305 296
- DE-A- 4 427 840
- US-A- 4 966 862
- US-A- 5 187 547
- US-A- 5 214 306
- US-A- 5 345 092
- US-A1- 2002 093 023
- US-B1- 6 281 524
- PATENT ABSTRACTS OF JAPAN vol. 018, no. 144 (E-1521), 10. März 1994 (1994-03-10) -& JP 05 327012 A (SANYO ELECTRIC CO), 10. Dezember 1993 (1993-12-10)

## Beschreibung

Die Erfindung betrifft einen strahlungsemittierenden Halbleiterchip nach dem Oberbegriff des Patentanspruches 1. Sie betrifft weiterhin ein Verfahren zum Herstellen eines solchen Halbleiterchips und ein strahlungsemittierendes Bauelement mit einem solchen Halbleiterchip.

Die Erfindung bezieht sich im Besonderen auf einen strahlungsemittierenden Halbleiterchip mit einer auf einem SiC-basierten Aufwachssubstrat aufgebrachten Nitrid-basierten strahlungsemittierenden aktiven Mehrschichtstruktur und auf ein mit einem solchen strahlungsemittierenden Halbleiterelement ausgestattetes strahlungsemittierendes optisches Bauelement.

Typischerweise werden für strahlungsemittierende optische Bauelemente, insbesondere für Lumineszenzdioden-Bauelemente, derzeit im Wesentlichen ausschließlich quaderförmige strahlungsemittierende Halbleiterchips praktisch eingesetzt, die in der Regel in transprarentes Vergußmaterial eingebettet sind. Eine große Schwierigkeit bereitet hierbei der große Unterschied der Brechungsindices von üblichen Halbleitermaterialien optischer Halbleiterelemente (n > 2,5) und den herkömmlich zur Verfügung stehenden Vergußmaterialien (zum Beispiel Epoxidharz; n_{Epoxy} ≅ 1,5). Der Grenzwinkel der Totalreflexion an der Grenzfläche zwischen Halbleiterkörper und Vergußmaterial ist folglich sehr klein. Dies ist Ursache dafür, daß aufgrund von Totalreflexion an den Chipoberflächen ein erheblicher Teil des in der aktiven Zone erzeugten Lichts nicht aus dem Halbleiterkörper ausgekoppelt wird und in dessen Innerem verloren geht. Bei vorgegebenem elektrischen Strom, der das Halbleiter-Bauelement zur Erzeugung des Lichts durchfließt, ist damit die Helligkeit des Bauelements begrenzt.

Bei GaN-basierten Leuchtdiodenchips, bei denen die Epitaxieschichtenfolge auf einem Substrat (beispielsweise einem Siliziumcarbid-Substrat) angeordnet ist, das einen höheren Brechungsindex aufweist als die Epitaxieschichtenfolge, tritt zudem das besondere Problem auf, dass bei herkömmlicher quaderartiger Chipgeometrie der durch die Substratflanken ausgekoppelte Strahlunganteil in einem sehr spitzen Winkel zur Substratflanke in Richtung Chiprückseite ausgekoppelt wird. Diese Strahlung trifft somit in einem sehr steilen Winkel und sehr nah am Chip auf eine Gehäusemontagefläche, auf der der Chip befestigt ist. Dies zieht die Nachteile nach sich, dass erstens aufgrund des spitzen Einfallswinkels ein großer Teil der Strahlung in der Chipmontagefläche absorbiert wird und zweitens eine erhebliche Gefahr besteht, dass ein gewisser Teil der Strahlung auf den zur Befestigung des Chips üblicherweise verwendeten Leitkleber trifft und von diesem absorbiert wird.

In der DE 198 07 758 A1 ist ein strahlungsemittierender Halbleiterkörper vorgeschlagen, bei dem zur Lichtausbeute-Erhöhung der aktiven Zone in der vorgesehenen Abstrahlrichtung des Halbleiterkörpers eine sogenannte primäre Fensterschicht nachgeordnet ist, dessen durchgehende Seitenoberfläche mit der Erstreckungsebene der mehrschichtigen Heterostruktur einen stumpfen Winkel einschließt. Die durchgehende Seitenoberfläche schließt mit der Ebene der aktiven Zone einen stumpfen Winkel zwischen 110° und 140° ein. Die primäre Fensterschicht ist hierbei von dem Aufwachssubstrat oder von einer auf diesem gesondert aufgewachsenen epitaxialen Schicht gebildet.

Zusätzlich kann der Halbleiterkörper gemäß DE 198 07 758 A1 eine weitere, sogenannte sekundäre Fensterschicht aufweisen, die an der von der primären Fensterschicht abgewandten Seite der aktiven Zone, das heißt an der Unterseite des Halbleiterkörpers, mittels Epitaxie oder Waferbonden aufgebracht ist und deren durchgehende Seitenoberfläche mit der Ebene der aktiven Zone einen Winkel zwischen 40° und 70° einschließt. Der Halbleiterkörper weist folglich von der Oberseite zur Unterseite durchgehend schräg stehende Chipflanken auf.

Diese Chipgeometrie dient in erster Linie dazu, die parallel zur aktiven Zone verlaufende Oberfläche des Chips größer als die aktive Zone zu machen und zu erreichen, daß Licht, das auf die schräg stehenden Seitenwände des primären Fensters auftrifft, zur vorgesehenen Abstrahlrichtung hin vollständig intern zu reflektieren.

Die sekundäre Fensterschicht erfüllt zusätzlich die Aufgabe, von der aktiven Zone nach hinten, das heißt in Richtung Montagefläche des Halbleiterkörpers ausgesandtes Licht über die schräg stehenden Seitenflächen der sekundären Fensterschicht aus dem Halbleiterkörper auszukoppeln.

Um eine Auskopplung von Licht in Rückwärtsrichtung zu vermindern und dieses Licht vorzugsweise bereits im Halbleiterkörper zur Vorderseite hin umzulenken, ist eine reflektierende Beschichtung der gesamten schräg stehenden Chipflanken vorgeschlagen.

Diese bekannte Chipgeometrie, die in erster Linie auf die Verbesserung der Lichtauskopplung über die Vorderseite gerichtet ist, wirft insbesondere folgende Probleme auf:
(i) Bei der Herstellung der schrägen Seitenflächen geht ein erheblicher Flächenanteil der auf dem Wafer vorhandenen aktiven Epitaxieschichtenfolge verloren, weil diese mittels Herstellen eines V-förmigen Grabens von der Seite der aktiven Zone her erzeugt werden.
(ii) Die Dicke der sekundären Fensterschicht ist stark begrenzt, damit eine ausreichend große Chip-Montagefläche erhalten bleibt, bei der
   - kein Verkippen des Chips bei dessen Montage in ein Leuchtdiodengehäuse auftritt,
   - eine Stromaufweitung auf möglichst die gesamte aktive Zone gewährleistet ist,
   - eine ausreichende Wärmeabfuhr von der aktiven Zone gesichert ist und
   - der Chip ausreichende mechnische Stabilität aufweist. Sie beträgt daher bevorzugt nur ca. 10 bis 40% der seitlichen Breite der aktiven Zone.
(iii) Die schrägen Seitenflanken bilden zusammen mit der Chipmontagefläche eines Leuchdiodengehäuses einen keilförmigen Spalt aus, der bei herkömmlichen Kunststoff-LED-Gehäusen in der Regel mit transparentem Vergußmaterial gefüllt ist. Bei Erhöhung der Bauelementtemperatur während des Betriebs und/oder aufgrund Erhöhung der Umgebungstemperatur, wie sie beispielsweise bei Anwendungen in Kraftfahrzeugen auftritt, wirken aufgrund der hohen thermischen Ausdehnung üblicher Vergußmassen erhebliche mechanische Kräfte auf den Chip, wodurch die Gefahr einer Delamination des Chips von der Chipmontagefläche des Gehäuses im Vergleich zu quaderförmigen Chips erheblich gesteigert ist.
(iv) Die Herstellung der sekundären Fensterschicht ist mit einem erhelblichen technischen Aufwand verbunden, weil diese zusätzlich separat aufgewachsen oder mittels Waferbonden zusätzlich aufgebracht werden muß.
(v) Die untere Fläche des Chips, die die Montagefläche darstellt, ist die kleinste Fläche des Halbleiterkörpers, über der der weitausladende obere Fensterbereich angeordnet ist. Daher beseht die große Gefahr, daß bei einer herkömmlich in der Chipmontage eingesetzten automatischen Chip-Montagetechnik, in der Regel ein Pick- and Place-Verfahren, eine Verkippung des Chips und damit ein Verkippung der Abstrahlachse des entsprechenden Leuchtdiodenbauelements auftreten kann. Diese Gefahr wird reduziert, wenn nur eine primäre Fensterschicht und keine sekundäre Fensterschicht vorhanden ist.
(vi) Die Dicke der eventuell vorhandenen unteren Fensterschicht muß aus den oben unter (ii) und (v) genannten Gründen möglichst gering gehalten werden. Dies bringt jedoch mit sich, daß dieses Fenster zu einem wesentlichen Teil von einem zur Montage von LeuchtdiodenChips üblicherweise verwendeten Klebstoff abgedeckt ist und damit nicht vollständig oder überhaupt nicht zur Lichtauskopplung beitragen kann.

Die Punkte (ii) und (v) nehmen mit abnehmender Kantenlänge des Chips, das heißt mit kleiner werdendem Querschnitt der aktiven Zone, was hinsichtlich möglichst großer Chipausbeute aus einem einzigen Wafer permanent angestrebt wird, an Bedeutung zu, denn je kleiner die Kantenlänge, umso kleiner wird bei der vorgeschlagenen Chipgeometrie sich ergebende Montagefläche des Chips. Die untere Fensterschicht ist aus diesen Gründen möglichst dünn ausgebildet oder weggelassen.

Die aus DE 198 07 758 A1 bekannte Chipgeometrie eignet sich, wenn überhaupt, praktisch sinnvoll nur für Materialsysteme auf der Basis von GaP, in dem sich dicke Schichten beider Leitungstypen epitaktisch erzeugen lassen, die ausreichend elektrisch leitend sind, um insbesondere die vorgeschlagene untere Fensterschicht realisieren und gleichzeitig eine Stromaufweitung auf annähernd die gesamte aktive Zone erzielen zu können.

Im Nitrid-basierten Halbleitermaterialsystem, das insbesondere GaN, InN und AlN und alle ternären und quaternären Mischristalle auf der Basis von GaN, InN und AlN, wie beispielsweise AlGaN, InGaN, AlInN und AlGaInN, umfaßt, weisen insbesondere p-leitend dotierte Schichten nur dann einen ausreichend geringen elektrischen Widerstand auf, wenn sie vergleichsweise dünn sind. Ein dickes unteres Fenster entsprechend der oben beschriebenen Anordnung läßt sich daher insbesondere bei herkömmlich verwendeten aktiven Schichtenfolgen auf der Basis von GaN, bei denen die untere Fensterschicht auf der p-leitenden Seite anzuordnen wäre, unter Inkaufnahme der oben dargelegten Schwierigkeiten nur mittels Waferbonden realisieren, was mit hohem technischen Aufwand verbunden ist.

Aus der US 5,233,204 ist eine Geometrie eines lichtemittierenden Halbleiterkörpers auf der Basis von InGaAlP bekannt, bei dem zwischen einem absorbierenden Substrat und einer aktiven Schichtstruktur eine dicke transparente Epitaxieschicht angeordnet ist, die aus GaP, GaAsP oder AlGaAs besteht. Die Seitenflächen der dicken transparenten Epitaxieschicht stehen schräg zur aktiven Schichtstruktur, derart, daß sich eine trichterfömige Schicht ergibt. Dadurch trifft mehr der von der aktiven Schichtstruktur zum Substrat hin ausgesandten Strahlung mit einem Winkel auf die Seitenfläche des transparenten Schicht, der kleiner als der Totalreflexionswinkel ist.

Bei der in der US 5,233,204 vorgeschlagenen Chipgeometrie treten aber erhebliche Lichtverluste auf. Zum einen aufgrund Totalreflexion an der Grenzfläche von der aktiven Schichtstruktur zur dicken transparenten Epitaxieschicht (Brechungsindex_{aktive Schicht} > BrechungsnindeX_{Fenster}) und nachfolgender Absorption in der aktiven Schichtenfolge. Zum anderen aufgrund Absorption im strahlungsabsorbierenden Aufwachssubstrat. Darüber hinaus erfordert die Herstellung der als dicke transparente Epitaxieschicht hergestellten Fensterschicht einen erheblichen zusätzlichen technischen Aufwand.

Zur Verbesserung der Lichtauskopplung ist an anderer Stelle vorgeschlagen worden, Halbleiterbauelemente mit beispielsweise dreiecksförmigem oder parallelogrammartigem lateralen Querschnitt zu erzeugen; siehe hierzu die Veröffentlichung Song Jae Lee, Seog Won Song: "Efficiency Improvement in Light-Emitting Diodes Based on Geometrically Deformed Chips", SPIE Conference on Light-Emitting Diodes, San Jose, California, January 1999, Seiten 237 bis 248. In diesen Anordnungen werden die Reflexionen im Chip erhöht, weil sich die Reflexionswinkel häufig ändern. Gleichzeitig müssen daher jedoch die strahlungserzeugende Schicht, die Kontakte oder andere Schichten des Halbleiterbauelements so ausgebildet sein, daß sie möglichst wenig Licht absorbieren.

Die Druckschrift DE 41 30 878 A1 offenbart ein Verfahren zur Herstellung von Halbleiterkörpern, die eine transparente Substratschicht aufweisen, bei dem in einen Trägerkörper Vertiefungen eingebracht werden, in denen zumindest ein Teil der transparenten Substratschicht abgeschieden wird.

Die Druckschriften JP 5-327012 und US 4,988,862 betreffen jeweils eine Leuchtdiode, bei der ein Halbleiterchip stellenweise von einer Schutzschicht überzogen ist.

Aufgabe der Erfindung ist es, einen für die Massenproduktion von Lumineszenzdioden-Bauelelmenten geeigneten strahlungsemittierenden Halbleiterchip der eingangs genannte Art mit verbesserter Lichtauskopplung anzugeben, bei dem insbesondere auch eine hohe Chipausbeute aus einem einzigen Wafer gewährleistet ist und der zur Montage in herkömmliche Lumineszenzdiodengehäuse mittels herkömmlicher in der Halbleitertechnik verwendeter automatischer Chip-Montageanlagen geeignet ist.

Weiterhin soll ein Verfahren zum Herstellen eines derartigen Halbleiterkörpers angegeben werden.

Eine weitere Aufgabe der Erfindung besteht darin, ein verbessertes strahlungsemittierendes optisches Bauelement anzugeben.

Diese Aufgaben werden durch ein Halbleiterbauelement mit den Merkmalen des Anspruches 1, durch ein optisches Bauelement mit Merkmalen des Anspruches 13 bzw. durch ein Verfahren mit den Merkmalen des Anspruches 17 gelöst.

Vorteilhafte Weiterbildungen und Ausführungsformen sind Gegenstand der Unteransprüche 2 bis 12, 14 bis 16 bzw. 18 bis 24.

Unter "Nitrid-basiert" fallen im Folgenden insbesondere alle binären, ternären und quaternären Stickstoff aufweisenden Halbleiter-Mischkristalle, wie GaN, InN, AlN, AlGaN, InGaN, InAlN und AlInGaN.

Unter "SiC-basiert" fällt jedes Mischkristall, dessen wesentliche Eigenschaften von den Bestandteilen Si und C geprägt sind.

Unter Aufwachssubstrat ist im Folgenden das für das epitaktische Aufwachsen der allerersten Schicht der aktiven Schichtenfolge zugrundegelegte Substrat zu verstehen.

Weiterhin ist im Folgenden unter Vorderseite oder Oberseite diejenige Seite des Halbleiterkörpers gemeint, die der aktiven Mehrschichtfolge in der vorgesehenen Abstrahlrichtung des Bauelements nachgeordnet ist. Mit Rückseite oder Unterseite ist folglich die von der Vorderseite abgewandte Seite des Halbleiterkörpers gemeint.

Bei dem Halbleiterkörper der eingangs genannten Art weist gemäß der Erfindung die transparente Fensterschicht mindestens eine Seitenwand auf, die, gesehen von der Mehrschichtstruktur in Richtung von der Mehrschichtstruktur weg über einen ersten Schichtdickenabschnitt der Fensterschicht schräg, gekrümmt oder stufenartig von einer senkrecht zur Aufwachsebene der Epitaxieschichten stehenden Mittelachse des Halbleiterkörpers weg verläuft.

Bei einer bevorzugten Ausführungsform verläuft die Seitenwand im weiteren Verlauf von der Mehrschichtstruktur weg über einen zweiten Schichtdickenabschnitt der Fensterschicht schräg, gekrümmt oder stufenartig zu der senkrecht zur Aufwachsebene der Epitaxieschichten stehenden Mittelachse des Halbleiterkörpers hin.

Bei einer anderen Ausführungsform steht im weiteren Verlauf von der Mehrschichtstruktur weg, das heißt über einen sich an den zweiten Schichtdickenabschnitt anschließenden dritten Schichtdickenabschnitt, die Seitenwand der Fensterschicht parallel zur Mittelachse, das heißt senkrecht zur Haupterstreckungsebene der Mehrschichtstruktur.

Die erfindungsgemäße Geometrie des Halbleiterkörpers hat den weiteren Vorteil, daß bei deren Herstellung der Verlust an aktiver Mehrschichtstruktur gering gehalten ist. Nahezu die gesamte Waferfläche kann als aktive Zone für die Halbleiterkörper genutzt werden. Die mit der erfindungsgemäßen Chipgeometrie erzielte Anzahl der Halbleiterkörper pro Wafer ist gegenüber der Herstellung herkömmlicher quaderförmiger Halbleiterkörper nur geringfügig verringert.

Die erfindungsgemäße Geometrie des Halbleiterkörpers eignet sich besonders bevorzugt insbesondere für Halbleiterkörper mit einer Nitrid-basierten aktiven Mehrschichtstruktur (das heißt aus dem Materialsystem In_{1-x-y}AlₓGa_{y}N mit 0≤x≤1, 0≤y≤1 und x+y≤1) auf einem SiC-basierten Substrat oder einem anderen transparenten Substrat, dessen Material einen größeren Brechungsindex aufweist als die aktive Mehrschichtstruktur. Ein Grund hierfür ist, daß Nitrid-basierte Schichten nur dann einen ausreichend geringen elektrischen Widerstand aufweisen, wenn diese sehr dünn sind. Dies trifft ganz besonders für p-dotierte derartige Schichten zu.

Der erfindungsgemäße Halbleiterkörper mit dem sich verjüngenden Fensterbereich ist aufgrund eines gegenüber herkömmlichen quaderförmgen Chips verbesserten Überlapps des Winkelbereichs von auf die Substratflanken auftreffender Strahlung mit dem durch die Substratflanken auskoppelbaren Winkelbereich in der Lage, einen vergleichsweise großen Teil der in der aktiven Zone erzeugten Strahlung bereits beim ersten Chipdurchlauf, das heißt beim ersten Auftreffen von Strahlung auf die Chipoberfläche, auszukoppeln. Damit ist die Totalreflexion an den Seitenflächen reduziert, die direkte Lichtauskopplung erhöht und die Absorption durch lange optische Wege und viele Reflexionen im Bauelement bzw. angrenzenden Fensterbereichen verringert.

Der sich schräg, gekrümmt oder stufenartig verjüngende Teil der Fensterschicht ist beispielsweise derart ausgebildet, daß ein Großteil der von dem Halbleiterbauelement durch die Seitenflanken ausgekoppelten Strahlung bezogen auf die Mittelachse des Halbleiterbauelements im Winkelbereich zwischen 50° und 90° abgestrahlt wird. Damit wird erreicht, daß bei herkömmlich für Lumineszenzdioden-Bauelemente verwendeten Gehäuse-Bauformen mit Reflektor die seitlich durch die Fensterschicht ausgekoppelte Strahlung auf die schräg stehenden Seitenwände des Reflektors treffen. Dies hat den bedeutenden Vorteil, daß die Strahlung in einem vergleichsweise stumpfen Winkel auf die Reflektor-Innenwände trifft, wodurch insbesondere bei Kunststoff-Reflektorwänden eine verbesserte Reflexion erreicht wird.

Bei herkömmlichen quaderförmigen Chips trifft dagegen der Hauptteil der durch die Fensterschicht ausgekoppelten Strahlung wegen des steilen Abstrahlwinkels von den Chipflanken auf den Reflektorboden, von dem zum einen wegen des steileren Auftreffwinkels der Strahlung und zum anderen wegen der unvermeidbaren teilweisen Abdeckung des Bodens mit Klebstoff vergleichsweise wenig Strahlung reflektiert wird.

Weiterhin besonders bevorzugt weist das Material der Fensterschicht einen größeren Brechungsindex auf als das an diese angrenzende Material der aktiven Mehrschichtstruktur. Dadurch wird vorteilhafterweise die Reflexion der von der aktiven Zone nach hinten ausgesandten Strahlung an der Grenzfläche zwischen Mehrschichtstruktur und Fensterschicht vermindert und es erfolgt eine Komprimierung der in die Fensterschicht eingekoppelten Strahlung.

Die erfindungsgemäße Chipgeometrie wird besonders bevorzugt bei Nitrid-basierten LED-Chips verwendet, bei dem die aktive Mehrschichtstruktur auf einem SiC- oder SiC-basierten Aufwachs-Substrat hergestellt ist. Hier gilt Brechungsindex_{aktive Schicht} > Brechungsnindex_{Substrat}.

Bei einem Chip mit quadratischem Querschnitt ist das Verhältnis Kantenlänge Mehrschichtstruktur/Kantenlänge Fenstervorderseite bevorzugt größer als 1. Bei ebenen schrägen Seitenflächen des Fensters schließen diese mit der Mittelachse des Halbleiterbauelements besonders bevorzugt einen Winkel α ungleich 0° und ungleich 90° ein, für den vorzugsweise gilt 20° ≤ α ≤ 70°.

Bei dieser Ausgestaltung ist einerseits eine gute Stromaufweitung auf die Fläche der Mehrschichtstruktur gewährleistet und liegt andererseits der Spannungsabfall in der Fensterschicht im Betrieb des Halbleiterchips in einem akzeptablen Bereich.

In einer weiteren vorteilhaften Ausgestaltung ist vorgesehen, daß mindestens der schräge, gekrümmte oder stufenartige Bereich der Fensterschicht aufgerauht ist.

Besonders vorteilhaft ist es, wenn die Fensterschicht aus dem Aufwachssubstrat geformt ist, wie zum Beispiel bei einer Nitrid-basierten Vebindungshalbleiter-Mehrschichtstruktur aus einem SiC-basierten Aufwachssubstrat.

Bei einem strahlungsemittierenden optischen Bauelement gemäß der Erfindung, das einen strahlungsemittierenden Halbleiterchip mit den oben offenbarten Merkmalen enthält, ist der Halbleiterchip in Top-Down-Montage, das heißt mit der strahlungsemittierenden Mehrschichtstruktur nach unten in einer Reflektor-Ausnehmung eines Gehäuse-Grundkörpers montiert. Die Reflektor-Ausnehmung weist bevorzugt eine vorzugsweise ebene Bodenfläche auf, auf die der strahlungsemittierende Halbleiterchip montiert ist und die von einer ebenen, schräg zur Bodenfläche stehenden Reflektorwand zumindest teilweise umschlossen ist. Der Gehäuse-Grundkörper ist aus einem reflektierenden Material, insbesondere aus einem entsprechenden Kunststoff, der vorzugsweise mit reflexionssteigerndem Material gefüllt ist, gefertigt und weist elektrische Anschlußelemente auf. Der Halbleiterchip ist mit seiner Mehrschichtstruktur, genauer mit einer auf dieser aufgebrachten Kontakt- und Verbindungsschicht auf die Bodenfläche aufgesetzt und beispielsweise mittels elektrisch leitendem Klebstoff oder metallischem Lot als elektrisch leitendem Verbindungsmittel mit dieser verbunden.

Die Höhe der Isolierschicht entlang der Seitenflächen der Mehrschichtstruktur und des ersten Seitenflächenbereichs der Fensterschicht ist so gewählt, daß das elektrisch leitende Verbindungsmittel keinen Kurzschluß zwischen Montageseite der Mehrschichtstruktur und Fensterschicht herstellen kann.

Bei einer besonderen Ausführungsform sind die seitlichen Reflektorwände derart parabolartig ausgebildet, daß eine über den schrägen, gekrümmten oder stufenartigen zweiten Seitenwandbereich ausgekoppelte und auf diese Flächen treffende Strahlung zu einer Abstrahlrichtung des Bauelements hin umgelenkt werden, insbesondere weitesgehend parallel in eine vorgegebene Richtung zur aktiven Schicht nach oben reflektiert werden.

Die Reflektorwände können vorteilhafterweise auf einfache Weise hochreflektierend ausgebildet sein, beispielsweise mittels A1- oder Ag-Beschichtung. Die Gefahr einer Kontamination der schräg stehenden Reflektorwände mit Klebstoff oder Lot bei der Montage des Halbleiterbauelements in das Gehäuse besteht zudem nicht.

Die Kontaktschicht, beispielsweise eine Kontaktmetallisierung an der Mehrschichtstruktur ist bevorzugt ein Gitterkontakt. Es wurde festgestellt, daß die Rückreflexion der zur Montageseite des Chips hin ausgesandten Strahlung in Richtung Vorderseite verbessert ist, wenn die Rückseiten-Kontaktmetallisierung nicht ganzflächig ausgebildet ist und die Zwischenräume zwischen den Gitterlinien vorzugsweise mit besser reflektierendem Material gefüllt sind.

Bei einem Verfahren zur gleichzeitigen Herstellung einer Vielzahl von strahlungsemittierenden Bauelementen gemäß der Erfindung ist vorgesehen, daß nach dem Aufbringen und vorzugsweise Strukturieren einer epitaktischen Schichtenfolge zu einer Vielzahl von nebeneinander angeordneten aktiven Mehrschichtstrukturen und Aufbringen der Isolationsschicht auf einem großflächigen Substratwafer in den Substratwafer zwischen den vorzugsweise vorher voneinander separierten Mehrschichtstrukturen von der Seite der Mehrschichtstrukturen her erste Form-Sägeschnitte eingebracht werden, deren Profil dem gewünschten Profil des ersten Seitenflächenbereichs entspricht. Nachfolgend werden von der der Mehrschichtstruktur abgewandten Seite des Substratwafers her in diesen gegenüber den ersten Sägeschnitten zweite Form-Sägeschnitte eingebracht, deren Profil dem geünschten Profil der zweiten Seitenwandbereiche entspricht, bevor dann die gegebenenfalls verbliebene noch nicht durchsägte Substratdicke beispielsweise mittels Brechen, Lasertrennen oder Sägen durchtrennt wird, so dass voneinander getrennte strahlungsemittierende Halbleiterchips entstehen.

Erfoderlichenfalls weisen bei den ersten und zweiten Sägeschnitten die Sägeblätter Formränder auf. Unter Formrand ist vorliegend eine nach bestimmten Maßgaben geformte Stirnseite des Sägeblattes zur Herstellung einer vorgesehenen Geometrie des Sägegrabens zu verstehen. Der Formrand weist vorliegend die Negativ-Form des schrägen, gekrümmten oder stufenartigen Teiles der Fensterschicht auf und ist folglich V-förmig, gekrümmt oder stufenartig ausgebildet.

Besonders bevorzugt erfolgt vor dem Einsägen mittels dem Sägeblatt mit Formrand ein Durchtrennen der aktiven Mehrschichtstruktur entlang der vorgesehenen Sägeschnitte, vorzugsweise mittels Ätzen.

Bei einer weiterhin bevorzugten Ausführungsart des Verfahrens ist vorgesehen, daß die Kontaktflächen, insbesondere gebildet durch Metallisierungsschichten, bereits vor dem Einsägen des Substratwafers hergestellt werden.

Bei einer besonders bevorzugten Weiterbildung des Verfahrens wird zunächst auf einem SiC-basierten Substratwafer eine GaNbasierte Epitaxieschichtenfolge aufgebracht, die geeignet ist, Strahlung im ultravioletten, blauen und/oder grünen Spektralbereich auszusenden. Das Substratmaterial ist vorzugsweise so gewählt, daß es zumindest für einen Großteil der von der aktiven Zone der Mehrschichtstruktur ausgesandten Strahlung zumindest teildurchlässig ist und einen größeren Brechungsindex aufweist als das Material der Epitaxieschichtenfolge.

Nachfolgend werden auf der Vorderseite der Epitaxieschichtenfolge und auf der Rückseite des Substratwafers Kontaktschichten aufgebracht, bevor danach die Epitaxieschichtenfolge bevorzugt mittels Ätzen zu einer Vielzahl von voneinander getrennten aktiven Mehrschichtstrukturen separiert wird.

Danach erfolgen die Form-Sägeschritte.

Bei einer vorteilhaften Weiterbildung wird der Substratwafer vor Durchführung der zweiten Form-Sägeschnitte gedünnt, beispielsweise mittels Schleifen und/oder Ätzen.

Weitere bevorzugte Ausführungsformen und Weiterbildungen der Erfindung ergeben sich aus den nachstehend in Verbindung mit den Figuren 1 bis 12D beschriebenen Ausführungsbeispielen. Es zeigen:
- Figur 1: eine schematische Darstellung eines Querschnitts durch einen strahlungsemittierenden Halbleiterchip;
- Figur 2: eine schematische Darstellung eines Querschnitts eine erste Ausführungsform eines erfindungsgemä- ßen strahlungsemittierenden Halbleiterchips, durch
- Figur 3: eine schematische Darstellung eines Querschnitts eine zweite Ausführungsform eines erfindungsgemä- ßen strahlungsemittierenden Halbleiterchips, durch
- Figur 4: eine schematische Darstellung eines Querschnitts einen strahlungsemittierenden Halbleiterchip, durch
- Figur 5: eine schematische Darstellung eines Querschnitts eine dritte Ausführungsform eines erfindungsgemä- ßen strahlungsemittierenden Halbleiterchips, durch
- Figur 6: eine schematische Darstellung eines Querschnitts durch eine vierte Ausführungsform eines erfindungsgemä- ßen strahlungsemittierenden Halbleiterchips, durch
- Figur 7: eine schematische Darstellung eines Querschnitts einen strahlungsemittierenden Halbleiterchip,
- Figur 8: eine schematische Darstellung eines Querschnitts durch eine fünfte Ausführungsform eines erfindungsgemäßen ßen strahlungsemittierenden Halbleiterchips,
- Figur 9: eine schematische Darstellung eines Querschnitts durch eine sechste Ausführungsform eines erfindungsgemä- ßen strahlungsemittierenden Halbleiterchips,
- Figur 10: eine schematische Darstellung eines Querschnitts durch eine siebte Ausführungsform eines erfindungsgemä- ßen strahlungsemittierenden Halbleiterchips,
- Figur 11: eine schematische Darstellung eines Querschnitts durch ein erfindungsgemäßes strahlungsemittierendes Bau- element, und
- Figuren 12A bis 12D: eine schematische Darstellung von Verfah- rensschritten zur gleichzeitigen Herstellung von erfin- dungsgemäßen Halbleiterchips.

In den Figuren sind jeweils gleiche oder gleichwirkende Bestandteile der Ausführungsbeispiele jeweils mit den gleichen Bezugszeichen versehen.

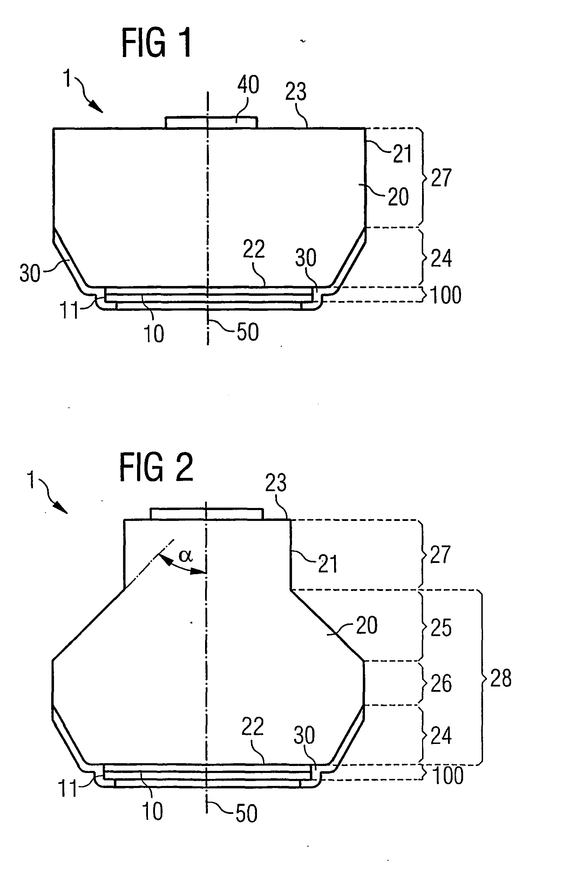

Die Ausführungsform von Figur 1, die nicht Teil dieser Erfindung ist, zeigt rein schematisch einen Querschnitt durch einen strahlungsemittierenden Halbleiterchip 1. Eine das Licht erzeugende aktive Schicht 10, zum Beispiel eine Einfach-Quantentopf(SQW für Single Quantum Well)- oder Mehrfach-Quantentopf(MQW für Multi Quantum Well)-Struktur auf der Basis von InGaN, liegt innerhalb einer Mehrschichtstruktur 100, die beispielsweise insgesamt aus einer Mehrzahl von Nitrid-basierten Halbleiterschichten besteht. Der genaue Aufbau einer solchen Mehrschichtstruktur ist abhängig vom Materialsystem und den gewünschten Eigenschaften des Bauelements. Einzelheiten hierzu sind aus dem Stand der Technik bekannt und werden von daher im vorliegenden Zusammenhang nicht näher erläutert.

Die Mehrschichtstruktur 100 ist zum Beispiel durch metallorganische Gasphasenepitaxieverfahren auf einer Fensterschicht 20 hergestellt, die an ihrer von der Mehrschichtstruktur abgewandten Seite 23 einen elektrischen Kontakt 40 aufweist. Die Mehrschichtstruktur 100 weist auf ihrer von der Fensterschicht 20 abgewandten Seite einen zweiten elektrischen Kontakt 60 auf, der im Ausführungsbeispiel großflächig die Mehrschichtstruktur 100 bedeckt. Der elektrische Kontakt 60 ist vorzugsweise reflektierend ausgebildet oder weist eine zusätzliche Reflexionsschicht auf.

Der Kontakt 60 kann auch eine Gitterstruktur aufweisen und zwischen den Gitterlinien kann Material angeordnet sein, das für eine von der Mehrschichtstruktur ausgesandte Strahlung eine bessere Reflektivität aufweist.

Die Fensterschicht 20 ist aus dem Aufwachssubstratmaterial gebildet, und besteht vorzugsweise aus Siliziumcarbid oder aus einem auf SiC basierenden Material, während die Mehrschichtstruktur 100 auf Galliumnitridbasis ausgebildet ist. Das bedeutet, daß die Mehrschichtstruktur 100 neben Stickstoff beispielsweise die Elemente Indium, Aluminium und/oder Gallium enthält. In diesem Materialsystem sind p-dotierte Schichten nur dann hinreichend elektrisch leitend, wenn sie vergleichsweise dünn sind.

In einem anderen Materialsystem können die Schichten der Mehrschichtenfolge 100 und das Substrat anders ausgebildet sein. Beispielsweise ist im Materialsystem InGaAlP eine Leitfähigkeit bei dicken Schichten möglich. Das Substrat kann Saphir oder SiC sein. Während deshalb im diesem Materialsystem oberhalb der Mehrschichtstruktur 100 noch ein transparentes Fenster aufgewachsen sein kann, ist die Ausbildung eines derartigen epitaktisch aufgewachsenen Fensters im Materialsystem von Galliumnitrid nicht möglich.

Die Fensterschicht 20 weist mindestens eine umlaufende Seitenfläche 21 auf, die im Verlauf von der der Mehrschichtstruktur 100 zugewandten ersten Hauptfläche 22 in Richtung zu der von der Mehrschichtstruktur 100 abgewandten zweiten Hauptfläche 23 der Fensterschicht 20 hin zunächst einen derart abgeschrägten und um den Chip vollständig umlaufenden ersten Seitenflächenbereich 24 aufweist, dass sich die Fensterschicht gegenüber der Größe der ersten Hauptfläche 22 zunächst verbreitert. Im Anschluß an diesen abgeschrägten ersten Seitenwandteil 24 weist die Fensterschicht 20 einen senkrecht zur Haupterstreckungsebene der Mehrschichtstruktur 100 stehenden Seitenflächenbereich 27 auf. Die umlaufende Seitenfläche 11 der Mehrschichtstruktur 100 und der abgeschrägte Seitenwandteil 24 sind mit einer durchgehenden elektrisch isolierenden Schicht 30 überzogen, die beispielsweise aus Siliziumoxid oder Siliziumnitrid besteht.

Dieser Halbleiterchip 21 ist zur Top-Down-Montage bestimmt.

Die Ausführungsform von Figur 2 unterscheidet sich von der von Figur 1 insbesondere dadurch, dass dem ersten Seitenflächenbereich 24 im weiteren Verlauf zur zweiten Hauptfläche 23 hin zunächst ein im Wesentlichen senkrecht zur Haupterstrekkungsebene der Mehrschichtstruktur 100 stehender Seitenwandbereich 26 und sich nachfolgend die Fensterschicht 20 über einen schräg zur Haupterstreckungsebene der Mehrschichtstruktur 100 verlaufenden Seitenwandbereich 25 wieder verjüngt. Diesem sich verjüngenden Teil der Fensterschicht 20 ist wiederum ein senkrecht zur Haupterstreckungsebene der Mehrschichtstruktur 100 stehender Seitenwandbereich 27 nachgeordnet, der bis zur zweiten Hauptfläche 23 der Fensterschicht 20 führt. Der schräg stehende Seitenwandbereich 25, über den sich die Fensterschicht 20 verjüngt, ist vorzugsweise vollständig um den Chip umlaufend und schließt mit einer senkrecht zur Haupterstreckungsebene der Mehrschichtstruktur 100 stehenden Achse 50 einen Winkel α ein, der zwischen 10° und 80°, bevorzugt zwischen 20° und 60° liegt.

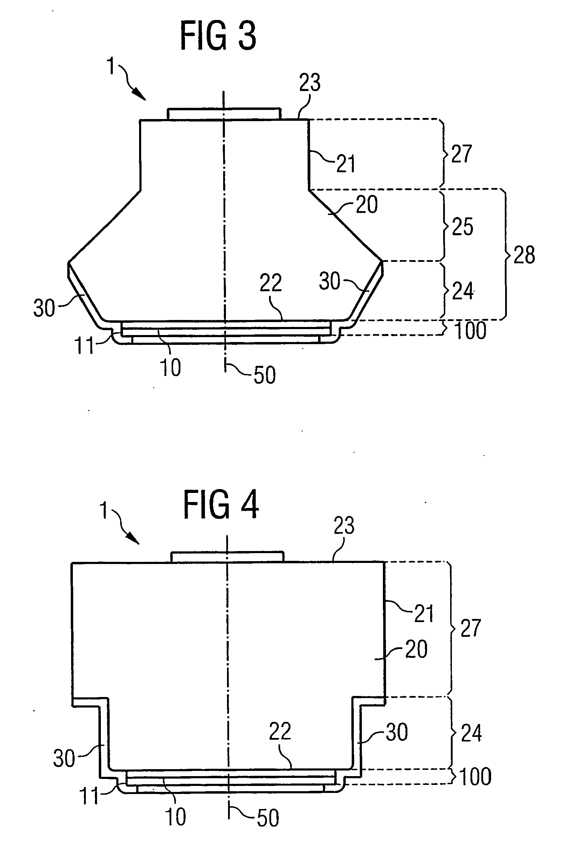

Die Ausführungsform von Figur 3 unterscheidet sich von der von Figur 2 insbesondere darin, dass zwischen dem ersten schräg stehenden Seitenwandbereich 24 und dem zweiten schräg stehenden Seitenwandbereich 25 der senkrecht zur Haupterstreckungsebene der Mehrschichtstruktur 100 stehende Seitenwandbereich 26 von Figur 2 nicht vorhanden ist.

Bei der Ausführungsform von Figur 4, die nicht Teil dieser Erfindung ist, ist ausgehend von der ersten Hauptfläche 22 der Fensterschicht ein um den Chip vollständig umlaufender gestufter Seitenwandteil 24 in Form einer rechtwinkligen Schulter ausgebildet, der ein senkrecht zur Haupterstreckungsebene der Mehrschichtstruktur 100 stehender Seitenwandbereich 27 nachgeordnet ist, der bis zur zweiten Hauptfläche 23 der Fensterschicht 20 führt. Die umlaufende Seitenfläche 11 der Mehrschichtstruktur 100 und der gestufte Seitenwandteil 24 sind mit einer durchgehenden elektrisch isolierenden Schicht 30 überzogen, die beispielsweise aus Siliziumoxid oder Siliziumnitrid besteht.

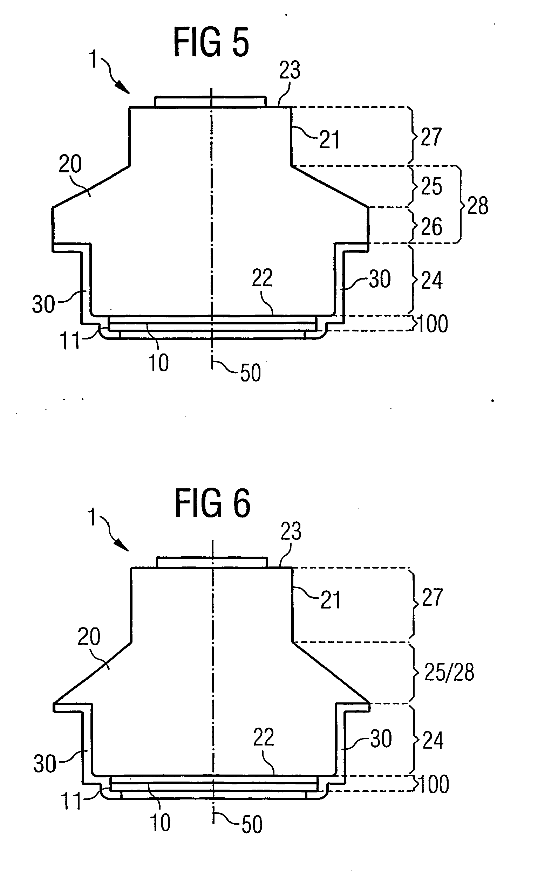

Die Ausführungsform von Figur 5 unterscheidet sich von der von Figur 4 insbesondere dadurch, dass dem ersten Seitenflächenbereich 24 im weiteren Verlauf zur zweiten Hauptfläche 23 hin zunächst ein im Wesentlichen senkrecht zur Haupterstrekkungsebene der Mehrschichtstruktur 100 stehender Seitenwandbereich 26 und sich nachfolgend die Fensterschicht 20 über einen schräg zur Haupterstreckungsebene der Mehrschichtstruktur 100 verlaufenden Seitenwandbereich 25 wieder verjüngt. Diesem sich verjüngenden Teil 25 der Fensterschicht 20 ist wiederum ein senkrecht zur Haupterstreckungsebene der Mehrschichtstruktur 100 stehender Seitenwandbereich 27 nachgeordnet, der bis zur zweiten Hauptfläche 23 der Fensterschicht 20 führt. Der schräg stehende Seitenwandbereich 25, über den sich die Fensterschicht 20 verjüngt, ist vorzugsweise vollständig um den Chip umlaufend und schließt mit einer senkrecht zur Haupterstreckungsebene der Mehrschichtstruktur 100 stehenden Achse 50 einen Winkel α ein, der zwischen 10° und 80°, bevorzugt zwischen 20° und 60° liegt.

Die Ausführungsform von Figur 6 unterscheidet sich von der von Figur 5 insbesondere darin, dass zwischen dem ersten schräg stehenden Seitenwandbereich 24 und dem zweiten schräg stehenden Seitenwandbereich 25 der senkrecht zur Haupterstreckungsebene der Mehrschichtstruktur 100 stehende Seitenwandbereich 26 von Figur 2 nicht vorhanden ist.

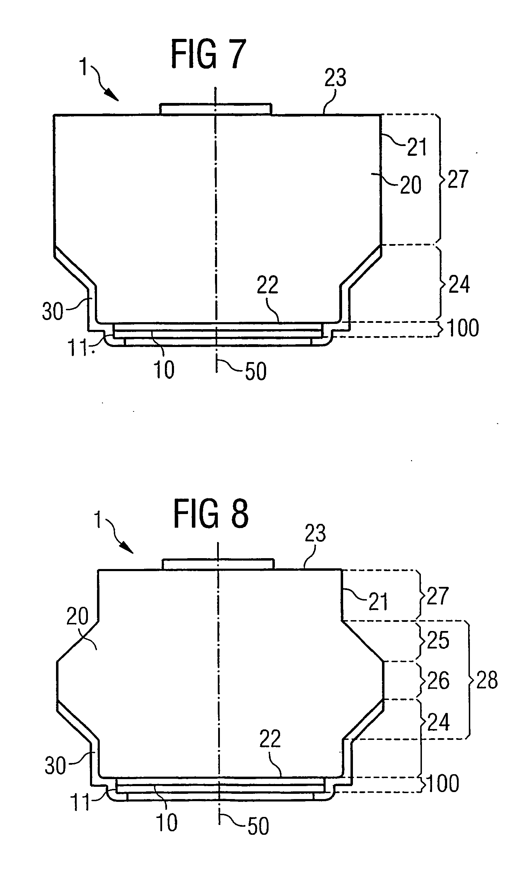

Bei der Ausführungsform von Figur 7, die nicht Teil dieser Erfindung ist, ist ausgehend von der ersten Hauptfläche 22 der Fensterschicht ein um den Chip vollständig umlaufender gestufter Seitenwandteil 24 in Form einer stumpfwinkligen Schulter ausgebildet, der ein senkrecht zur Haupterstreckungsebene der Mehrschichtstruktur 100 stehender Seitenwandbereich 27 nachgeordnet ist, der bis zur zweiten Hauptfläche 23 der Fensterschicht 20 führt. Die umlaufende Seitenfläche 11 der Mehrschichtstruktur 100 und der gestufte Seitenwandteil 24 sind mit einer durchgehenden elektrisch isolierenden Schicht 30 überzogen, die beispielsweise aus Siliziumoxid oder Siliziumnitrid besteht.

Die Ausführungsform von Figur 8 unterscheidet sich von der von Figur 7 insbesondere dadurch, dass dem ersten Seitenflächenbereich 24 im weiteren Verlauf zur zweiten Hauptfläche 23 hin zunächst ein im Wesentlichen senkrecht zur Haupterstrekkungsebene der Mehrschichtstruktur 100 stehender Seitenwandbereich 26 und sich nachfolgend die Fensterschicht 20 über einen schräg zur Haupterstreckungsebene der Mehrschichtstruktur 100 verlaufenden Seitenwandbereich 25 wieder verjüngt. Diesem sich verjüngenden Teil 25 der Fensterschicht 20 ist wiederum ein senkrecht zur Haupterstreckungsebene der Mehrschichtstruktur 100 stehender Seitenwandbereich 27 nachgeordnet, der bis zur zweiten Hauptfläche 23 der Fensterschicht 20 führt. Der schräg stehende Seitenwandbereich 25, über den sich die Fensterschicht 20 verjüngt, ist vorzugsweise vollständig um den Chip umlaufend und schließt mit einer senkrecht zur Haupterstreckungsebene der Mehrschichtstruktur 100 stehenden Achse 50 einen Winkel α ein, der zwischen 10° und 80°, bevorzugt zwischen 20° und 60° liegt.

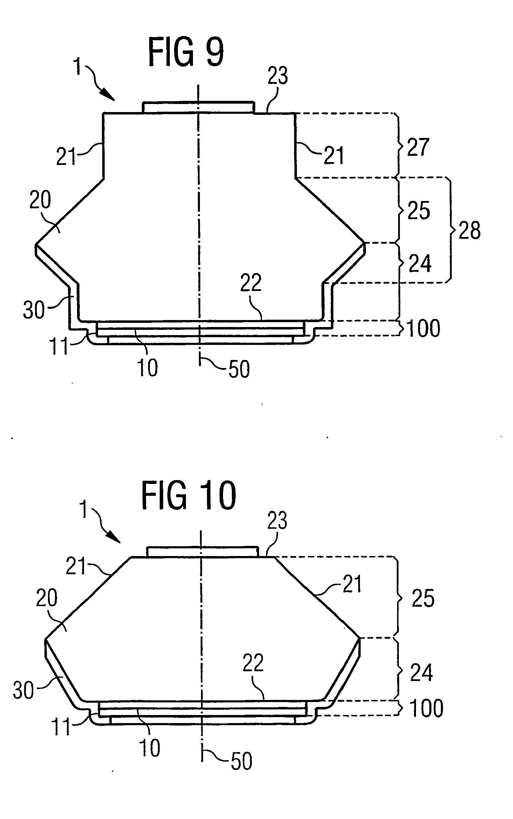

Die Ausführungsform von Figur 9 unterscheidet sich von der von Figur 8 insbesondere darin, dass zwischen dem ersten schräg stehenden Seitenwandbereich 24 und dem zweiten schräg stehenden Seitenwandbereich 25 der senkrecht zur Haupterstreckungsebene der Mehrschichtstruktur 100 stehende Seitenwandbereich 26 von Figur 2 nicht vorhanden ist.

Bei den Ausführungsformen der Figuren 2,3,5,6,8 und 9 bilden die Seitenwandbereiche 24,25 und ggf. 26 eine umlaufende Auskragung 28 aus, die einerseits eine isolierende Beschichtung 30 ermöglicht und andererseits eine Verbesserung der Auskopplung der Strahlung aus dem Chip durch den schräg stehenden Seitenwandteil 25 bewirkt.

Bei der Ausführungsform von Figur 10 schließt sich anders als bei der Ausführungform von Figur 9 an den zweiten schräg stehenden Seitenwandteil 25 kein senkrecht zur Haupterstrekkungsebene der Mehrschichtstruktur 100 stehender Seitenwandteil 27 an, sondern bildet der zweite schräg stehende Seitenwandteil 25 mit der zweiten Hauptfläche 23 unmittelbar eine Kante aus. Diese Ausführungsvariante kann ebenso bei den Ausführungsfomren der Figuren 2,3,5,6 und 8 angewendet werden. Vorteilhafterweise wird bei dieser Ausführungsvariante der Spannungsabfall im Chip reduziert.

Die oben beschriebenen schräg stehenden Seitenwandteile können alternativ geeignet gekrümmt oder gestuft ausgebildet sein. Sie können weiterhin aufgerauht sein. Ebenso können zusätzlich gegebenenfalls auch die Seitenwandteile 26 und 27 aufgerauht sein.

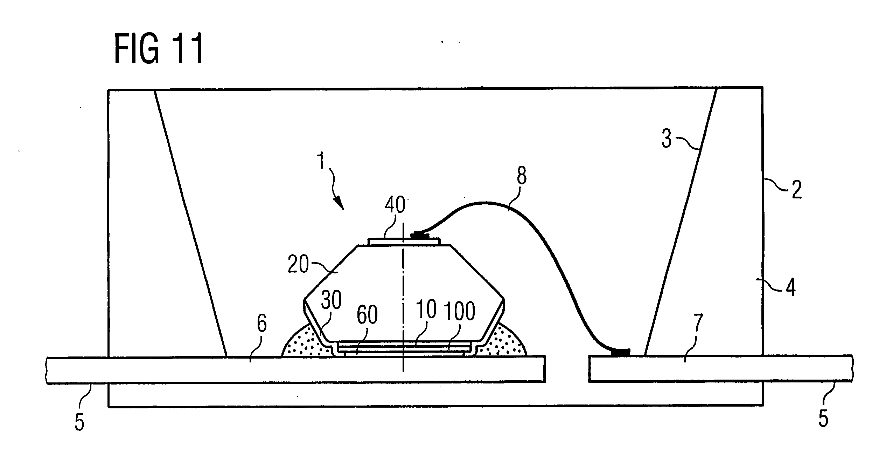

Bei dem in Figur 11 dargestellten strahlungsemittierenden Baulement ist ein strahlungsemittierender Chip 1 gemäß der Ausführungsform von Figur 10 in einer Ausnehmung 3 eines Gehäusegrundkörpers 4 eines Bauelementgehäuses 2 mittels eines elektrisch leitfähigen Klebers oder mittels eines metallischen Lotes auf eine Chipmontagefläche 6 eines elektrischen Leiterrahmens 5 (Leadframe) montiert, derart, dass die Mehrschichtstruktur 100 mit dem Kontakt 60 zur Chiptmontagefläche 6 hin gewandt ist und die Fensterschicht 20 auf der von der Chipmontagefläche 6 abgewandten Seite der Mehrschichtstruktur 100 angeordnet ist. Bei dieser Montageart handelt es sich um die sogenannte Top-Down-Montage. Der Kontakt 40 auf der Fensterschicht ist mittels eines Bonddrahtes 8 mit einer Drahtanschlußfläche 7 des Leiterrahmens 5 verbunden. Die Ausnehmung 3 ist beispielweise mit einem strahlungsdurchlässigen Reaktionsharz gefüllt und die Seitenflächen der Ausnehmung 3 sind vorzugsweise reflektierend ausgebildet, so dass die Ausnehmung einen Reflektor für eine vom Chip seitlich ausgesandte Strahlung bildet.

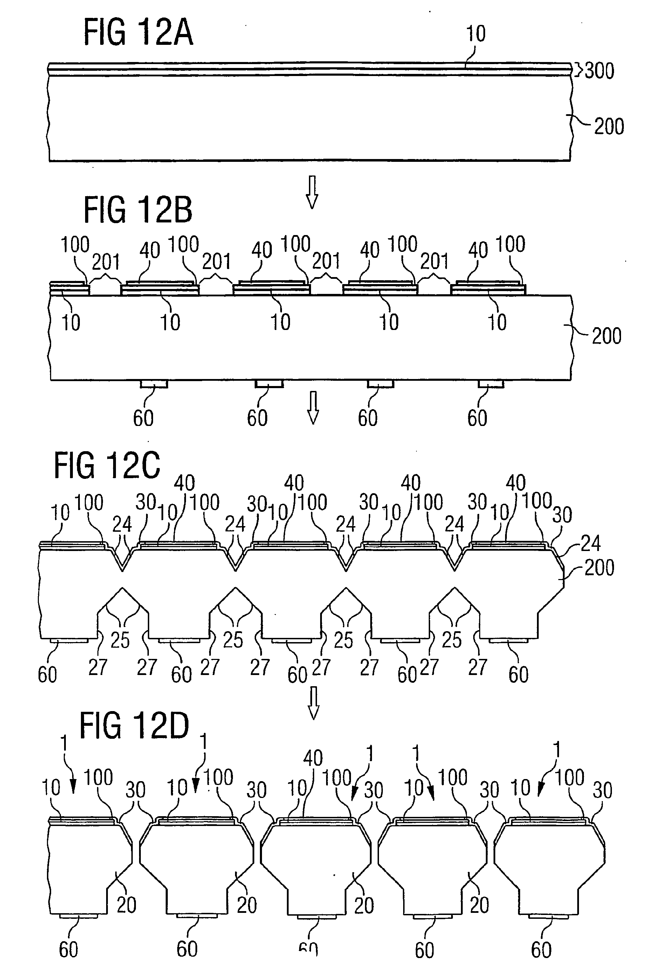

Bei dem in Figur 12 schematisch dargestellten Verfahrensausschnitt eines Verfahrens zum gleichzeitigen Herstellen einer Vielzahl von Halbleiterchips gemäß der Ausführungsform von Figur 8 wird zunächst auf einem Substratwafer 200 eine Mehrschichtenfolge 300 aufgewachsen, der aus einem Material gefertigt ist, das für eine von der aktiven Schicht 10 ausgesandte Strahlung durchlässig ist. Danach wird die Mehrschichtenfolge in eine Vielzahl von voneinander separierten Mehrschichtstrukturen 100 strukturiert, dass zwischen den Mehrschichtstrukturen 100 Trennspuren 201 ausgebildet werden, die bis auf den Subtstratwafer 200 reichen. Nachfolgend werden die ersten Seitenwandbereiche 24, insbesondere mittels Einsägen des Substratwafers zwischen den Mehrschichtstrukturen 100 mit einem Sägeblatt mit V-förmigem Formrand hergestellt, bevor dann die elektrisch isolierende Schicht 30 auf die Seitenflächen der Mehrschichtstrukturen 100 und auf die ersten Seitenwandbereiche 24 aufgebracht wird. Nach diesem Prozessschritt wird der Substratwafer 200 von der von den Mehrschichtstrukturen 100 abgewandeten Seite her entlang den Trennspuren 201 mit einem Sägeblatt mit V-förmigem Formrand eingesägt, so dass die zweiten abgeschrägten Seitenwandbereiche 25 sowie die Seitenwandbereiche 27 entstehen. Dem folgt das Durchtrennen des Substratwafers 200 entlang den Trennspuren 201, insbesondere mittels Brechen oder Lasertrennen oder mittels eines weiteren Sägeschnittes, so dass die Vielzahl von voneinander getrennten Halbleiterchips 1 entstehen.

Sollen die Seitenwandbereiche 27 nicht entstehen, so können dazu entweder die Sägeschnitte zum Herstellen der zweiten schrägstehenden Seitenwandtbereiche 25 nicht so tief ausgeführt werden oder der Substratwafer 200 vorher von dessen von den Mehrschichtstrukturen 100 abgewandten Seite her entsprechend gedünnt werden, beispielsweise mittels Schleifen oder Ätzen.

Die Kontakte 40 und 60 werden zu einem geeigneten Zeitpunkt abhängig vom exakten Ablauf des Verfahrens hergestellt.

Das oben beschriebene Verfahrensprinzip läßt sich in entsprechend der jeweils gewünschten Chipgeometrie geringfügig abgewandelter Form für die Herstellung sämtlicher Chipgeometrien der oben beschriebenen Ausführungsformen (Figuren 1 bis 10) anwenden.

## Patentansprüche

1. Strahlungsemittierender Halbleiterchip, mit einer Mehrschichtstruktur (100), die eine strahlungsemittierende aktive Schicht (10) enthält, und mit einer Fensterschicht (20), die für eine von der aktiven Schicht (10) ausgesandte Strahlung durchlässig ist und die eine der Mehrschichtstruktur (100) zugewandte erste Hauptfläche (22) sowie eine von der Mehrschichtstruktur (100) abgewandten zweite Hauptfläche (23) aufweist, wobei
- der Halbleiterchip zur Montage in einem Chipgehäuse mit der Mehrschichtstruktur nach unten vorgesehen ist,
- die Fensterschicht (20) eine umlaufende Seitenfläche (21) aufweist, die im Verlauf von der der Mehrschichtstruktur (100) zugewandten ersten Hauptfläche (22) in Richtung zu der von der Mehrschichtstruktur (100) abgewandten zweiten Hauptfläche (23) hin zunächst einen derart abgeschrägten, gekrümmten oder gestuften ersten Seitenflächenbereich (24) aufweist, dass sich die Fensterschicht (20) gegenüber der Größe der ersten Hauptfläche (22) verbreitert,
- die Mehrschichtstruktur (100) eine umlaufende Seitenfläche (11) aufweist und die Seitenfläche (11) der Mehrschichtstruktur (100) und zumindest ein Teil des abgeschrägten, gekrümmten oder gestuften ersten Seitenflächenbereiches (24) mit einer durchgehenden elektrisch isolierenden Schicht (30) überzogen sind, **dadurch gekennzeichnet, dass**
- dem ersten Seitenflächenbereich (24) im weiteren Verlauf zur zweiten Hauptfläche (23) hin ein abgeschrägter, gekrümmter oder gestufter zweiter Seitenflächenbereich (25) nachgeordnet ist, über dessen Länge sich die Fensterschicht (20) wieder verjüngt, und
- vermittels der abgeschrägten, gekrümmten oder gestuften ersten und zweiten Seitenflächenbereiche (24;25) an der Fensterschicht (20) eine umlaufende Auskragung (28) ausgebildet ist, die von der Mehrschichtstruktur (100) gesehen seitlich über die erste Hauptfläche (22) und über die umlaufende Seitenfläche (11) der Mehrschichtstruktur hinausragt.

2. Strahlungsemittierender Halbleiterchip nach Anspruch 1, **dadurch gekennzeichnet, dass** die Fensterschicht (20) zwischen dem ersten Seitenflächenbereich (24) und dem zweiten Seitenflächenbereich (25) einen senkrecht zur Mehrschichtstruktur stehenden dritten Seitenflächenbereich (26) aufweist.

3. Strahlungsemittierender Halbleiterchip nach mindestens einem der vorherigen Ansprüche, **dadurch gekennzeichnet, dass** dem ersten Seitenflächenbereich (24) und dem zweiten Seitenflächenbereich (25) ein senkrecht zur Haupterstreckungsebene der Mehrschichtstruktur (100) stehender weiterer Seitenflächenbereich (27) nachgeordnet ist.

4. Strahlungsemittierender Halbleiterchip nach mindestens einem der vorherigen Ansprüche, **dadurch gekennzeichnet, dass** die Fensterschicht (20) Teil eines zum epitaktischen Aufwachsen der Mehrschichtenfolge (100) genutzten Aufwachssubstrates ist.

5. Strahlungsemittierender Halbleiterchip nach mindestens einem der vorherigen Ansprüche, **dadurch gekennzeichnet, dass** die Mehrschichtstruktur (100) an ihrer von der Fensterschicht (20) abgewandten Seite eine Reflexionsschicht zur Reflexion einer von der strahlungsemittierenden aktiven Schicht (10) ausgesandten Strahlung zur Fensterschicht (20) hin aufweist.

6. Strahlungsemittierender Halbleiterchip nach mindestens einem der vorherigen Ansprüche, **dadurch gekennzeichnet, dass** der Brechungsindex des Materials der Fensterschicht (20) größer als der Brechungsindex des an die Fensterschicht (20) angrenzenden Materials der Mehrschichtstruktur (100) ist.

7. Strahlungsemittierender Halbleiterchip nach mindestens einem der vorherigen Ansprüche, **dadurch gekennzeichnet, dass** die Fensterschicht (20) aus Siliziumkarbid (SiC) besteht oder auf SiC basiert und die Mehrschichtfolge aus Nitrid-basierten Halbleitermaterialien, insbesondere aus GaN-basierten Halbleitermaterialien gefertigt ist.

8. Strahlungsemittierender Halbleiterchip nach mindestens einem der vorherigen Ansprüche, **dadurch gekennzeichnet, dass** sämtliche Seitenflächenbereiche (24,25,26,27) vollständig um die Fensterschicht (20) umlaufend ausgebildet sind.

9. Strahlungsemittierender Halbleiterchip nach mindestens einem der vorherigen Ansprüche, **dadurch gekennzeichnet, dass** der zweite Seitenflächenbereich (25) eine ebene schrägstehende Fläche aufweist, die mit einer senkrecht zur Haupterstreckungsebene der strahlungsemittierenden aktiven Schicht (10) stehenden Achse (50) einen Winkel (α) einschließt, der zwischen einschließlich 20° und einschließlich 70° liegt.

10. Strahlungsemittierender Halbleiterchip nach mindestens einem der vorherigen Ansprüche, **dadurch gekennzeichnet, dass** zumindest der zweite Seitenflächenbereich (25) aufgerauht ist.

11. Strahlungsemittierender Halbleiterchip nach Anspruch 2 oder nach Anspruch 3 bis 10 unter Rückbezug auf Anspruch 2, **dadurch gekennzeichnet, dass** der dritte Seitenflächenbereich (26) aufgerauht ist.

12. Strahlungsemittierender Halbleiterchip nach Anspruch 3 oder nach Anspruch 4 bis 11 unter Rückbezug auf Anspruch 3, **dadurch gekennzeichnet, dass** der weitere Seitenflächenbereich (27) aufgerauht ist.

13. Strahlungsemittierendes Bauelement mit einem strahlungsemittierenden Halbleiterchip nach einem der Ansprüche 1 bis 12 und einem Bauelementgehäuse mit einer Chipmontagefläche, auf der der Halbleiterchip derart montiert ist, dass die Mehrschichtstruktur zur Chipmontagefläche hin gewandt ist.

14. Strahlungsemittierendes Bauelement nach Anspruch 13, bei dem der Halbleiterchip mittels eines elektrisch leitfähigen Klebers oder mittels eines metallischen Lotes auf der Chipmontagefläche befestigt wird.

15. Strahlungsemittierendes Bauelement nach Anspruch 13 oder 14, bei dem das Bauelementgehäuse eine Reflektorwanne (410) mit schrägstehenden oder parabolartigen Seitenwänden (350) aufweist, in der der Halbleiterchip montiert ist.

16. Strahlungsemittierendes Bauelement nach Anspruch 15, bei dem Seitenwände der Reflektorwanne mit reflexionssteigerndem Material beschichtet sind.

17. Verfahren zum gleichzeitigen Herstellen einer Vielzahl von strahlungsemittierenden Halbleiterchips gemäß mindestens einem der Ansprüche 1 bis 12, mit folgenden Verfahrensschritten:
(a) Aufwachsen einer Mehrschichtenfolge (300), die eine strahlungsemittierende aktive Schicht (10) enthält, auf einen Substratwafer (200), der aus einem Material gefertigt ist, das für eine von der aktiven Schicht (10) ausgesandte Strahlung durchlässig ist;
(b) Strukturieren der Mehrschichtenfolge in eine Vielzahl von voneinander separierten Mehrschichtstrukturen (100) auf dem Substratwafer, derart, dass zwischen den Mehrschichtstrukturen (100) Trennspuren ausgebildet werden, die bis auf den Substratwafer reichen;
(c) Herstellen der ersten Seitenflächenbereiche (24);
(d) Aufbringen der elektrisch isolierenden Schicht (30) auf die Seitenflächen der Mehrschichtstrukturen (100) und auf die ersten Seitenflächenbereiche (24);
(e) Durchtrennen des Substratwafers entlang der Trennspuren zu einzelnen Fensterschichten (20), so dass die Vielzahl von voneinander getrennten Halbleiterchips entsteht,
wobei vor Schritt (e) in dem Substratwafer von der von den Mehrschichtstrukturen (100) abgewandten Seite her entlang der Trennspuren die zweiten Seitenflächenbereiche (25) ausgebildet werden.

18. Verfahren gemäß Anspruch 17, bei dem die ersten Seitenflächenbereiche (24) mittels Einsägen des Substratwafers zwischen den Mehrschichtstrukturen (100) mit einem Sägeblatt mit V-förmigem, gekrümmtem oder gestuftem Formrand hergestellt werden.

19. Verfahren gemäß Anspruch 17 oder 18, bei dem das Durchtrennen des Substratwafers entlang der Trennspuren mittels Brechen oder Lasertrennen erfolgt.

20. Verfahren gemäß einem der Ansprüche 17 bis 19, bei dem die Ausbildung der zweiten Seitenflächenbereiche (25) mittels Einsägen des Substratwafers mit einem Sägeblatt mit schrägem, gekrümmtem oder gestuftem Formrand, der die Negativform der vorgesehenen Form der zweiten Seitenflächenbereiche (25) aufweist, erfolgt.

21. Verfahren nach einem der Ansprüche 17 bis 20, bei dem vor Schritt (e) der Substratwafer von der von den Mehrschichtstrukturen (100) abgewandten Seite her gedünnt wird.

22. Verfahren nach mindestens einem der Ansprüche 17 bis 21, bei dem das Durchtrennen von Schritt (e) durch ein Brechverfahren, ein Lasertrennverfahren oder ein Sägeverfahren erfolgt.

23. Verfahren nach mindestens einem der Ansprüche 17 bis 22, bei dem vor dem Durchtrennen des Substratwafers auf den freien Oberflächen des Substratwafers bzw. der Mehrschichtstrukturen Metallkontakte hergestellt werden.

24. Verfahren nach mindestens einem der Ansprüche 17 bis 23, bei dem die Fensterschicht (20) aus einem für ein epitaktisches Aufwachsen der Mehrschichtenfolge (100) genutzten Aufwachssubstratkörpers herausgeformt wird.

## Claims

1. Radiation-emitting semiconductor chip, having a multilayer structure (100) containing a radiation-emitting active layer (10), and having a window layer (20), which is transmissive to a radiation emitted by the active layer (10) and has a first main area (22) facing the multilayer structure (100) and also a second main area (23) remote from the multilayer structure (100),
wherein
- the semiconductor chip is provided for mounting in a chip housing with the multilayer structure toward the bottom,
- the window layer (20) has a peripheral side area (21), which, in the course from the first main area (22) facing the multilayer structure (100) in the direction toward the second main area (23) remote from the multilayer structure (100), firstly has a first side area region (24) which is beveled, curved or stepped in such a way that the window layer (20) widens with respect to the size of the first main area (22),
- the multilayer structure (100) has a peripheral side area (11) and the side area (11) of the multilayer structure (100) and at least a part of the beveled, curved or stepped first side area region (24) are coated with a continuous electrically insulating layer (30),
**characterized in that** - a beveled, curved or stepped second side area region (25) is arranged downstream of the first side area region (24) in the further course toward the second main area (23), over the length of which second side area region the window layer (20) tapers again, and
- a peripheral protrusion (28) is formed by means of the beveled, curved or stepped first and second side area regions (24; 25) at the window layer (20), which protrusion projects laterally beyond the first main area (22) and beyond the peripheral side area (11) of the multilayer structure as seen from the multilayer structure (100).

2. Radiation-emitting semiconductor chip according to Claim 1, **characterized in that** the window layer (20) has, between the first side area region (24) and the second side area region (25), a third side area region (26) perpendicular to the multilayer structure.

3. Radiation-emitting semiconductor chip according to at least one of the preceding claims, **characterized in that** a further side area region (27) perpendicular to the main plane of extent of the multilayer structure (100) is arranged downstream of the first side area region (24) and the second side area region (25).

4. Radiation-emitting semiconductor chip according to at least one of the preceding claims, **characterized in that** the window layer (20) is part of a growth substrate utilized for the epitaxial growth of the multilayer sequence (100).

5. Radiation-emitting semiconductor chip according to at least one of the preceding claims, **characterized in that** the multilayer structure (100) has, at its side remote from the window layer (20), a reflection layer for reflecting a radiation emitted by the radiation-emitting active layer (10) toward the window layer (20).

6. Radiation-emitting semiconductor chip according to at least one of the preceding claims, **characterized in that** the refractive index of the material of the window layer (20) is greater than the refractive index of the material of the multilayer structure (100) adjoining the window layer (20).

7. Radiation-emitting semiconductor chip according to at least one of the preceding claims, **characterized in that** the window layer (20) comprises silicon carbide (SiC) or is based on SiC and the multilayer sequence is produced from nitride-based semiconductor materials, in particular from GaN-based semiconductor materials.

8. Radiation-emitting semiconductor chip according to at least one of the preceding claims, **characterized in that** all the side area regions (24, 25, 26, 27) are formed completely peripherally around the window layer (20).

9. Radiation-emitting semiconductor chip according to at least one of the preceding claims, **characterized in that** the second side area region (25) has a planar oblique area which forms an angle (α) with an axis (50) perpendicular to the main plane of extent of the radiation-emitting active layer (10), said angle lying between 20° and 70° inclusive.

10. Radiation-emitting semiconductor chip according to at least one of the preceding claims, **characterized in that** at least the second side area region (25) is roughened.

11. Radiation-emitting semiconductor chip according to Claim 2 or according to Claims 3 to 10 with reference back to Claim 2, **characterized in that** the third side area region (26) is roughened.

12. Radiation-emitting semiconductor chip according to Claim 3 or according to Claims 4 to 11 with reference back to Claim 3, **characterized in that** the further side area region (27) is roughened.

13. Radiation-emitting component having a radiation-emitting semiconductor chip according to one of Claims 1 to 12 and a component housing having a chip mounting area on which the semiconductor chip is mounted in such a way that the multilayer structure faces toward the chip mounting area.

14. Radiation-emitting component according to Claim 13, in which the semiconductor chip is fixed on the chip mounting area by means of an electrically conductive adhesive or by means of a metallic solder.

15. Radiation-emitting component according to Claim 13 or 14, in which the component housing has a reflector well (410) with oblique or parabolic side walls (350), in which the semiconductor chip is mounted.

16. Radiation-emitting component according to Claim 15, in which side walls of the reflector well are coated with reflection-increasing material.

17. Method for simultaneously producing a multiplicity of radiation-emitting semiconductor chips according to at least one of Claims 1 to 12, having the following method steps:
(a) growth of a multilayer sequence (300) containing a radiation-emitting active layer (10) on a substrate wafer (200) produced from a material which is transmissive to a radiation emitted by the active layer (10) ;
(b) patterning of the multilayer sequence into a multiplicity of mutually separated multilayer structures (100) on the substrate wafer, in such a way that separating tracks reaching as far as the substrate wafer are formed between the multilayer structures (100);
(c) production of the first side area regions (24);
(d) application of the electrically insulating layer (30) to the side areas of the multilayer structures (100) and to the first side area regions (24);
(e) severing of the substrate wafer along the separating tracks to form individual window layers (20), thereby producing the multiplicity of mutually separate semiconductor chips,
before step (e), the second side area regions (25) are formed in the substrate wafer from the side remote from the multilayer structures (100) along the separating tracks.

18. Method according to Claim 17, in which the first side area regions (24) are produced by sawing into the substrate wafer between the multilayer structures (100) using a saw blade with a V-shaped, curved or stepped shaping edge.

19. Method according to Claim 17 or 18, in which the severing of the substrate wafer along the separating tracks is effected by means of breaking or laser separation.

20. Method according to any of Claims 17 to 19, in which the second side area regions (25) are formed by sawing into the substrate wafer using a saw blade with an oblique, curved or stepped shaping edge, which has the negative form of the envisaged form of the second side area regions (25).

21. Method according to any of Claims 17 to 20, in which, before step (e), the substrate wafer is thinned from the side remote from the multilayer structures (100).

22. Method according to at least one of Claims 17 to 21, in which the severing of step (e) is effected by a breaking method, a laser separation method or a sawing method.

23. Method according to at least one of Claims 17 to 22, in which, before the severing of the substrate wafer, metal contacts are produced on the free surfaces of the substrate wafer or the multilayer structures.

24. Method according to at least one of Claims 17 to 23, in which the window layer (20) is shaped from a growth substrate body utilized for an epitaxial growth of the multilayer sequence (100).

## Revendications

1. Puce semi-conductrice émettrice de rayonnement, qui présente une structure multicouche (100) contenant une couche (10) active émettrice de rayonnement et une couche de fenêtre (20) transparente pour le rayonnement émis par la couche active (10) et présentant une première surface principale (22) tournée vers la structure multicouche (100) ainsi qu'une deuxième surface principale (23) non tournée vers la structure multicouche (100),
la puce semi-conductrice étant prévue pour être montée dans un boîtier de puce avec sa structure multicouche tournée vers le bas,
la couche de fenêtre (20) présentant une surface latérale périphérique (21) qui, dans l'extension de la première surface principale (22) tournée vers la structure multicouche (100), présente d'abord une première partie (24) de surface latérale chanfreinée, courbée ou étagée en direction de la deuxième surface principale (23) non tournée vers la structure multicouche (100) de telle sorte que la couche de fenêtre (20) présente une plus grande taille que celle de la première surface principale (22),
la structure multicouche (100) présentant une surface périphérique latérale (11) et la surface latérale (11) de la structure multicouche (100) et au moins une partie de la première partie (24) de surface latérale chanfreinée, courbée ou étagée étant recouvertes par une couche électriquement isolante (30) continue,
**caractérisée en ce que**
une deuxième partie (25) de surface latérale chanfreinée, courbée ou étagée dans la suite de l'extension de la deuxième surface principale (23) et sur la longueur de laquelle la couche de fenêtre (20) se rétrécit à nouveau fait suite à la première partie (24) de surface latérale et
**en ce qu'**un collet périphérique (28) qui déborde de la structure multicouche (100) latéralement au-delà de la surface principale (22) et au-delà de la surface latérale périphérique (11) de la structure multicouche est formé sur la couche de fenêtre (20) au moyen de la première et de la deuxième partie (24; 25) de surface latérale chanfreinée, courbée ou étagée.

2. Puce semi-conductrice émettrice de rayonnement selon la revendication 1, **caractérisée en ce que** la couche de fenêtre (20) présente une troisième partie (26) de surface latérale perpendiculaire à la structure multicouche entre la première partie (24) de surface latérale et la deuxième partie (25) de surface latérale.

3. Puce semi-conductrice émettrice de rayonnement selon au moins l'une des revendications précédentes, **caractérisée en ce qu'**une autre partie (27) de surface latérale perpendiculaire au plan d'extension principal de la structure multicouche (100) fait suite à la première partie (24) de surface latérale et la deuxième partie (25) de surface latérale.

4. Puce semi-conductrice émettrice de rayonnement selon au moins l'une des revendications précédentes, **caractérisée en ce que** la couche de fenêtre (20) fait partie d'un substrat de croissance utilisé pour la croissance épitaxique de la succession multicouche (100).

5. Puce semi-conductrice émettrice de rayonnement selon au moins l'une des revendications précédentes, **caractérisée en ce que** sur son côté non tourné vers la couche de fenêtre (20), la structure multicouche (100) présente une couche réfléchissante qui réfléchit en direction de la couche de fenêtre (20) le rayonnement émis par la couche (10) active émettrice de rayonnement.

6. Puce semi-conductrice émettrice de rayonnement selon au moins l'une des revendications précédentes, **caractérisée en ce que** l'indice de réfraction du matériau de la couche de fenêtre (20) est supérieur à l'indice de réfraction du matériau de la structure multicouche (100) adjacent à la couche de fenêtre (20).

7. Puce semi-conductrice émettrice de rayonnement selon au moins l'une des revendications précédentes, **caractérisée en ce que** la couche de fenêtre (20) est constituée de carbure de silicium (SiC) ou est à base de SiC et **en ce que** la succession multicouche est réalisée à partir de matériaux semi-conducteurs à base de nitrures et en particulier de matériaux semi-conducteurs à base de GaN.

8. Puce semi-conductrice émettrice de rayonnement selon au moins l'une des revendications précédentes, **caractérisée en ce que** toutes les parties (24, 25, 26, 27) de surface latérale sont entièrement formées autour de la couche de fenêtre (20).

9. Puce semi-conductrice émettrice de rayonnement selon au moins l'une des revendications précédentes, **caractérisée en ce que** la deuxième partie (25) de surface latérale présente une surface oblique qui forme avec un axe (50) perpendiculaire au plan d'extension principal de la couche (10) active émettrice de rayonnement un angle (α) compris entre 20° inclus et 70° inclus.

10. Puce semi-conductrice émettrice de rayonnement selon au moins l'une des revendications précédentes, **caractérisée en ce qu'**au moins la deuxième surface latérale (25) est rendue rugueuse.

11. Puce semi-conductrice émettrice de rayonnement selon la revendication 2 ou selon les revendications 3 à 10 en référence à la revendication 2, **caractérisée en ce que** la troisième partie (26) de surface latérale est rendue rugueuse.

12. Puce semi-conductrice émettrice de rayonnement selon la revendication 3 ou selon les revendications 4 à 11 en référence à la revendication 3, **caractérisée en ce que** l'autre partie (27) de surface latérale est rendue rugueuse.

13. Composant émetteur de rayonnement doté d'une puce semi-conductrice émettrice de rayonnement selon l'une des revendications 1 à 12, et d'un boîtier de composant doté d'une surface de montage de puce sur laquelle la puce semi-conductrice est montée de telle sorte que la structure multicouche soit tournée vers la surface de montage de puce.

14. Composant émetteur de rayonnement selon la revendication 13, dans lequel la puce semi-conductrice est fixée sur la surface de montage de puce au moyen d'un adhésif électriquement conducteur ou au moyen d'une brasure métallique.

15. Composant émetteur de rayonnement selon les revendications 13 ou 14, dans lequel le boîtier du composant présente une cuvette réfléchissante (410) dont les parois latérales (350) sont obliques ou paraboliques, et dans laquelle la puce semi-conductrice est montée.

16. Composant émetteur de rayonnement selon la revendication 15, dans lequel les parois latérales de la cuvette réfléchissante sont revêtues d'un matériau qui renforce la réflexion.

17. Procédé de fabrication simultanée de plusieurs puces semi-conductrices émettant un rayonnement selon au moins l'une des revendications 1 à 12, présentant les étapes de procédé suivantes :
(a) faire croître une structure multicouche (300) qui contient une couche (10) active en émission de rayonnement sur une galette de substrat (200) réalisée en un matériau transparent pour le rayonnement émis par la couche active (10),
(b) structurer la succession multicouche en plusieurs structures multicouches (100) séparées les unes des autres sur la galette de substrat de telle sorte que des traces de séparation qui s'étendent jusqu'à la galette de substrat soient formées entre les structures multicouches (100),
(c) préparer les premières parties (24) de surface latérale,
(d) appliquer la couche électriquement isolante (30) sur les surfaces latérales des structures multicouches (100) et sur les premières parties (24) de surface latérale,
(e) découper la galette de substrat le long des traces de séparation en couches distinctes de fenêtre (20) de telle sorte que l'on obtient plusieurs puces semi-conductrices séparées les unes des autres,
les deuxièmes parties (25) de surface latérale étant formées avant l'étape (e) dans la galette de substrat, le long des traces de séparation, par le côté non tourné vers les structures multicouches (100).

18. Procédé selon la revendication 17, dans lequel les premières parties (24) de surface latérale sont formées par sciage de la galette de substrat entre les structures multicouches (100) à l'aide d'une lame de scie dont la bordure a la forme d'un V, une forme courbée ou une forme étagée.

19. Procédé selon les revendications 17 ou 18, dans lequel la séparation de la galette de substrat le long des traces de séparation s'effectue par rupture ou par séparation au laser.

20. Procédé selon l'une des revendications 17 à 19, dans lequel la formation des deuxièmes parties (25) de surface latérale s'effectue par sciage de la galette de substrat à l'aide d'une lame de scie dont la bordure a une forme oblique, courbe ou étagée qui présente la forme négative de la forme prévue pour les deuxièmes parties (25) de surface latérale.

21. Procédé selon l'une des revendications 17 à 20, dans lequel avant l'étape (e), la galette de substrat est amincie par son côté non tourné vers les structures multicouches (100).

22. Procédé selon au moins l'une des revendications 17 à 21, dans lequel la séparation de l'étape (e) s'effectue par une opération de rupture, une opération de découpe au laser ou une opération de sciage.

23. Procédé selon au moins l'une des revendications 17 à 22, dans lequel avant la découpe de la galette de substrat, des contacts métalliques sont réalisés sur les surfaces libres de la galette de substrat et les structures multicouches.

24. Procédé selon au moins l'une des revendications 17 à 23, dans lequel la couche de fenêtre (20) est formée d'un corps de substrat d'épitaxie utilisé pour la croissance épitaxique de la succession multicouche (100).
